# EUROPEAN PATENT APPLICATION

(11) **EP 4 601 005 A1**
(43) Date of publication of application: **13.08.2025**
(21) Application number: 22963169.2
(22) Date of filing: 28.10.2022
(51) Int. Cl.: H01L 23/522, G01S 17/02

(54) **INTEGRATED APPARATUS, MANUFACTURING METHOD, DETECTION APPARATUS AND TERMINAL**

(71) Applicant: Shenzhen Yinwang Intelligent Technologies Co., Ltd., Shenzhen, Guangdong 518129 (CN)
(72) Inventor: ZHANG, Yi, Shenzhen, Guangdong 518129 (CN); CAI, Zhonghua, Shenzhen, Guangdong 518129 (CN); ZHONG, Guowei, Shenzhen, Guangdong 518129 (CN)
(74) Representative: Maiwald GmbH
(86) International application number: PCT/CN2022/128334
(87) International publication number: WO 2024/087187

(57) **Abstract**

This application relates to the field of electronic technologies, and provides an integrated apparatus, a manufacturing method, a detection apparatus, and a terminal, to reduce parasitics introduced in the integrated apparatus, so as to improve effective energy conversion efficiency of the integrated apparatus. The detection apparatus may be a lidar. The integrated apparatus includes: a substrate, having at least two etching layers that are alternately stacked; and a laser, located on the substrate. At least one filling structure is disposed on a side that is of the substrate and that is away from the laser. The substrate and the filling structure may form a capacitor. The filling structure includes an insulator and a first metal layer. A height of the filling structure is less than a thickness of the substrate. The laser and the capacitor are disposed on the same substrate, to reduce a distance between the laser and the capacitor in a three-dimensional layout manner, and implement an interconnection between the laser and the capacitor. This greatly reduces the parasitics introduced in a structure of the integrated apparatus.

## Description

### TECHNICAL FIELD

This application relates to the field of electronic technologies, and in particular, to an integrated apparatus, a manufacturing method, a detection apparatus, and a terminal.

### BACKGROUND

A lidar (light detection and ranging, LiDAR) is an optical measurement device whose working principle is to emit a laser signal to an object, receive a target echo signal reflected by the object, and then compare the target echo signal with the laser signal, to obtain related parameters such as a location and a distance of the object. The lidar can accurately scan a surrounding object to form a high-definition image, helping quickly recognize the surrounding object and make decisions. Currently, the lidar has been widely used in scenarios such as intelligent vehicles, smart transportation, three-dimensional city mapping, and atmospheric environment monitoring.

The lidar has a plurality of components. Currently, a layout of the components on a printed circuit board (printed circuit board, PCB) introduces great extra parasitics. For example, a trace between the components on the PCB introduces an extra parasitic resistance, an extra parasitic inductance, and the like in a circuit. In addition, a longer trace leads to a larger parameter value of introduced parasitics. As a result, in a working process of the lidar, more energy is consumed by the parasitics, and effective energy conversion efficiency used for laser working is reduced.

### SUMMARY

This application provides an integrated apparatus, a manufacturing method, a detection apparatus, and a terminal, to reduce parasitics introduced in the integrated apparatus, so as to improve effective energy conversion efficiency of the integrated apparatus.

According to a first aspect, this application provides an integrated apparatus. The integrated apparatus includes: a substrate, having at least two etching layers that are alternately stacked, where the etching layer may be a dielectric layer in which a through hole or a groove can be formed through etching or photoetching; and a laser, located on the substrate, where the laser may be, for example, a laser diode that can emit laser light whose wavelength is 905 nanometers. At least one filling structure is disposed on a side that is of the substrate and that is away from the laser. The substrate and the filling structure may form a capacitor. The filling structure includes an insulator and a first metal layer. A height of the filling structure is less than a thickness of the substrate, that is, the filling structure does not penetrate the substrate. Optionally, the filling structure has different radial widths in the at least two etching layers.

In the foregoing technical solution, the laser and the capacitor are disposed on the same substrate, to reduce a distance between the laser and the capacitor in a three-dimensional layout manner, and implement an interconnection between the laser and the capacitor. Therefore, no extra interconnection trace needs to be disposed between the laser and the capacitor. This greatly reduces parasitics (for example, parasitic inductance and parasitic resistance) introduced in a structure of the integrated apparatus, thereby improving effective energy conversion efficiency of the integrated apparatus. The substrate has the at least two etching layers that are alternately stacked, so that the at least one filling structure disposed in the substrate can have different radial widths in different etching layers. This increases a specific surface area of the capacitor, thereby facilitating heat dissipation and reducing a heat loss.

In a possible implementation of the first aspect, the at least two etching layers have different etching selective materials. In a possible example, the at least two etching layers have two etching selective materials, and may specifically include an aluminum gallium arsenide AlGaAs layer and a gallium arsenide GaAs layer. In other words, the substrate includes the AlGaAs layer and the GaAs layer that are alternately stacked. In the foregoing possible implementation, when the two etching layers include the AlGaAs layer and the GaAs layer, a lattice constant of AlGaAs is different from a lattice constant of the GaAs layer, and the lattice constant of the AlGaAs is less than the lattice constant of the GaAs layer. Therefore, the AlGaAs layer and the GaAs layer undergo compression strain in an x direction and a y direction (namely, two directions parallel to the etching layer and perpendicular to each other), and undergo tensile strain in a z direction (namely, a direction perpendicular to the etching layer). In this way, electrons in the AlGaAs layer and the GaAs layer have large mobility, and a corresponding resistivity is low. This greatly reduces the parasitic resistance of the integrated apparatus, and improves performance of the integrated apparatus. In addition, because conductivity of the AlGaAs is good, resistance of the AlGaAs layer can be further reduced by using the AlGaAs layer, to further improve performance of the integrated apparatus.

In a possible implementation of the first aspect, when the at least two etching layers include the AlGaAs layer and the GaAs layer, the GaAs layer is an etching layer closest to the laser in the at least two etching layers. In the foregoing possible implementation, the GaAs layer is disposed at a location closest to the laser, to meet a current design requirement of the laser.

In a possible implementation of the first aspect, a thickness of the AlGaAs layer may be the same as or different from a thickness of the GaAs layer. In an example, the thickness of the AlGaAs layer is the same as the thickness of the GaAs layer.

In a possible implementation of the first aspect, an etching resistance of the AlGaAs layer is greater than an etching resistance of the GaAs layer. Correspondingly, a radial width of the filling structure in the AlGaAs layer may be greater than a radial width of the filling structure in the GaAs layer. In this way, the filling structure has different radial widths in the AlGaAs layer and the GaAs layer that are alternately stacked.

In a possible implementation of the first aspect, a part that is of the filling structure and that is located in the AlGaAs layer is distributed in a straight line, and a part that is of the filling structure and that is located in the GaAs layer is distributed in an arc line. In the foregoing possible implementation, the part that is of the filling structure and that is located in the AlGaAs layer is distributed in the straight line, and the part that is of the filling structure and that is located in the GaAs layer is distributed in the arc line, so that the filling structure can have a large surface area. This increases the specific surface area of the capacitor, thereby facilitating heat dissipation and reducing the heat loss.

In a possible implementation of the first aspect, the insulator is located between the substrate and the first metal layer, and is attached to the first metal layer. In the foregoing possible implementation, a design of the capacitor with a MIS structure is provided. To be specific, the capacitor includes the substrate, the insulator, and the first metal layer. In this case, the substrate may be a heavily doped substrate. The heavily doped substrate may also be referred to as a low-resistivity substrate.

In a possible implementation of the first aspect, the filling structure further includes a second metal layer. The second metal layer is located between the substrate and the insulator. In the foregoing possible implementation, a design of the capacitor with a MIM structure is provided. To be specific, the capacitor includes the substrate, the second metal layer, the insulator, and the first metal layer. In this case, the substrate may be a lightly doped or non-doped substrate. The lightly doped or non-doped substrate may also be referred to as a high-resistivity substrate.

In a possible implementation of the first aspect, the at least one filling structure includes a plurality of filling structures. Optionally, distances between any two adjacent filling structures in the plurality of filling structures may be the same or different.

In a possible implementation of the first aspect, the plurality of filling structures are in a comb shape. Optionally, heights of at least two comb teeth in the plurality of filling structures may be the same or different. A height of each comb tooth herein may be a height at which the comb tooth extends into the substrate. In an example, heights of the plurality of filling structures are all the same; or in the plurality of filling structures, heights of partial comb teeth are different from a height of another comb tooth.

According to a second aspect, this application provides a manufacturing method for an integrated apparatus. The method includes: forming a substrate, where the substrate has at least two etching layers that are alternately stacked, and the etching layer may be a dielectric layer in which a through hole or a groove can be formed through etching or photoetching; forming a laser on the substrate, where the laser may be a laser diode that can emit laser light whose wavelength is 905 nanometers; and forming at least one filling structure on a side that is of the substrate and that is away from the laser, where the substrate and the filling structure may form a capacitor, the filling structure includes an insulator and a first metal layer, and a height of the filling structure is less than a thickness of the substrate, that is, the filling structure does not penetrate the substrate.

In a possible implementation of the second aspect, the filling structure has different radial widths in the at least two etching layers. Optionally, the at least two etching layers have different etching selective materials.

In a possible implementation of the second aspect, the at least two etching layers include an aluminum gallium arsenide AlGaAs layer and a gallium arsenide GaAs layer. The forming a substrate includes: alternately forming the AlGaAs layer and the GaAs layer, to form the substrate having the AlGaAs layer and the GaAs layer that are alternately stacked.

In a possible implementation of the second aspect, a last layer in the AlGaAs layer and the GaAs layer that are alternately stacked is the GaAs layer. The forming a laser on the substrate includes: forming the laser on the GaAs layer of the substrate. In the foregoing possible implementation, the GaAs layer is disposed at a location closest to the laser, to meet a current design requirement of the laser.

In a possible implementation of the second aspect, a thickness of the AlGaAs layer may be the same as or different from a thickness of the GaAs layer. In an example, the thickness of the AlGaAs layer is the same as the thickness of the GaAs layer.

In a possible implementation of the second aspect, a radial width of the filling structure in the AlGaAs layer is greater than a radial width of the filling structure in the GaAs layer. In this way, the filling structure has different radial widths in the AlGaAs layer and the GaAs layer that are alternately stacked.

In a possible implementation of the second aspect, a part that is of the filling structure and that is located in the AlGaAs layer is distributed in a straight line, and a part that is of the filling structure and that is located in the GaAs layer is distributed in an arc line. In the foregoing possible implementation, the part that is of the filling structure and that is located in the AlGaAs layer is distributed in the straight line, and the part that is of the filling structure and that is located in the GaAs layer is distributed in the arc line, so that the filling structure can have a large surface area. This increases a specific surface area of the capacitor, thereby facilitating heat dissipation and reducing a heat loss.

In a possible implementation of the second aspect, the insulator is located between the substrate and the first metal layer. The forming at least one filling structure on a side that is of the substrate and that is away from the laser includes: etching the side that is of the substrate and that is away from the laser, to form at least one groove, where a height (which may also be referred to as a depth) of the groove is less than the thickness of the substrate; forming the insulator on a surface that is of the substrate and that has the at least one groove, where a thickness of the insulator is less than one half of a radial width of the groove; and forming the first metal layer on the insulator, to obtain the at least one filling structure. In the foregoing possible implementation, a design of the capacitor with a MIS structure is provided. To be specific, the capacitor includes the substrate, the insulator, and the first metal layer. In this case, the substrate may be a heavily doped substrate. The heavily doped substrate may also be referred to as a low-resistivity substrate.

In a possible implementation of the second aspect, the filling structure further includes a second metal layer. The second metal layer is located between the substrate and the insulator. The forming the insulator on a surface that is of the substrate and that has the at least one groove includes: forming the second metal layer on the surface that is of the substrate and that has the at least one groove; and forming the insulator on the second metal layer, where a sum of a thickness of the second metal layer and the thickness of the insulator is less than the half of the radial width of the groove. In the foregoing possible implementation, a design of the capacitor with a MIM structure is provided. To be specific, the capacitor includes the substrate, the second metal layer, the insulator, and the first metal layer. In this case, the substrate may be a lightly doped or non-doped substrate. The lightly doped or non-doped substrate may also be referred to as a high-resistivity substrate.

In a possible implementation of the second aspect, the at least one filling structure includes a plurality of filling structures. Optionally, distances between any two adjacent filling structures in the plurality of filling structures may be the same or different.

In a possible implementation of the second aspect, the plurality of filling structures are in a comb shape. Optionally, heights of at least two comb teeth in the plurality of filling structures may be the same or different. A height of each comb tooth herein may be a height at which the comb tooth extends into the substrate. In an example, heights of the plurality of filling structures are all the same; or in the plurality of filling structures, heights of partial comb teeth are different from a height of another comb tooth.

According to a third aspect, this application provides an integrated circuit. The integrated circuit includes the integrated apparatus according to any one of the first aspect and the possible implementations of the first aspect and a switch device. The switch device is coupled to the integrated apparatus.

According to a fourth aspect, this application provides a detection apparatus. The detection apparatus includes the integrated apparatus according to any one of the first aspect and the possible implementations of the first aspect.

According to a fifth aspect, this application provides a terminal. The terminal includes the integrated apparatus according to any one of the first aspect and the possible implementations of the first aspect. Optionally, the terminal is a vehicle.

It may be understood that, for beneficial effect that can be achieved by any one of the manufacturing method for an integrated apparatus provided above, the detection apparatus, and the terminal, correspondingly refer to the beneficial effect of the integrated apparatus provided above. Details are not described herein again.

### BRIEF DESCRIPTION OF DRAWINGS

FIG. 1 is a diagram of an application scenario of a lidar according to an embodiment of this application;
FIG. 2 is a diagram of an internal architecture of a lidar according to an embodiment of this application;
FIG. 3A is a diagram of a structure of a transmitting module according to an embodiment of this application;
FIG. 3B is a diagram of a structure of another transmitting module according to an embodiment of this application;
FIG. 4 is a diagram of a layout manner of components in a transmitting module according to an embodiment of this application;
FIG. 5 is a diagram of a structure of an integrated apparatus according to an embodiment of this application;
FIG. 6 is a diagram of a structure of another integrated apparatus according to an embodiment of this application;
FIG. 7 is a diagram of a structure of a capacitor according to an embodiment of this application;
FIG. 8 is a diagram of a structure of still another integrated apparatus according to an embodiment of this application;
FIG. 9 is a schematic flowchart of a manufacturing method for an integrated apparatus according to an embodiment of this application;
FIG. 10 is a cross-sectional view of an integrated apparatus in a manufacturing process according to an embodiment of this application; and
FIG. 11 is a schematic flowchart of another manufacturing method for an integrated apparatus according to an embodiment of this application.

### DESCRIPTION OF EMBODIMENTS

The following clearly and completely describes the technical solutions in embodiments of this application with reference to the accompanying drawings in embodiments of this application.

A "connection" in embodiments of this application may be an electrical connection, and a connection between two electrical elements may be a direct or indirect connection between the two electrical elements. For example, a connection between A and B may be a direct connection between A and B, or may be an indirect connection between A and B through one or more other electrical elements. For example, that A is connected to B may alternatively be that A is directly connected to C, C is directly connected to B, and Ais connected to B through C. In some scenarios, the "connection" may alternatively be understood as a coupling, for example, an electromagnetic coupling between two inductors. In conclusion, through the connection between A and B, electric energy can be transmitted between A and B.

An end name of an electronic element in embodiments of this application is merely an example for description, and may be understood as a connection end or a connection point, configured to connect to another circuit element. In another example, there may alternatively be another end name, connection end name, or connection point name. For example, in some scenarios, an end may also be referred to as a communication end, an information transmission end, a terminal, a connection end, a communication connection end, an information connection end, a connection point, a communication connection point, an information connection point, or an electrode.

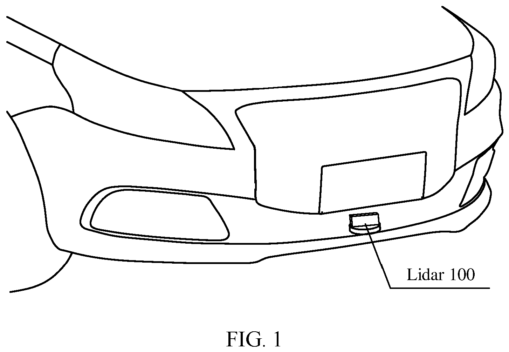

Embodiments of this application provide a circuit structure. In an application scenario, the circuit structure may be used in a detection apparatus, for example, a lidar. FIG. 1 is a diagram of an example of the application scenario of the lidar according to an embodiment of this application. In this example, the lidar 100 is mounted on a vehicle, and therefore is also referred to as a vehicle-mounted lidar. In addition to the vehicle-mounted lidar, the lidar further includes a shipborne lidar mounted on a ship, an airborne lidar mounted on a machine, or the like. In a possible example, as shown in FIG. 1, the lidar 100 may be mounted, for example, at a head location of the vehicle. In this way, in a travel process of the vehicle, the lidar 100 may send a laser signal. After being irradiated to an object in a surrounding environment, the laser signal is reflected by the object, a reflected target echo signal may be received by the lidar 100, and then the lidar 100 obtains information about the surrounding environment of the vehicle by performing detection based on the target echo signal, to assist or control a driving function, for example, including but not limited to autonomous driving or assisted driving, of the vehicle by using the environment information.

The lidar 100 may be one of a mechanical lidar, a liquid lidar, a pure solid-state lidar, or a hybrid solid-state lidar (also referred to as a semi-solid-state lidar), or may be another type of lidar. This is not specifically limited in embodiments of this application. In addition, a housing of the lidar 100 may be a cuboid shown in FIG. 1, or may be a cube, a cylinder, an annular body, an amorphous body, or the like. A shape of the housing of the detection apparatus is not specifically limited in embodiments of this application.

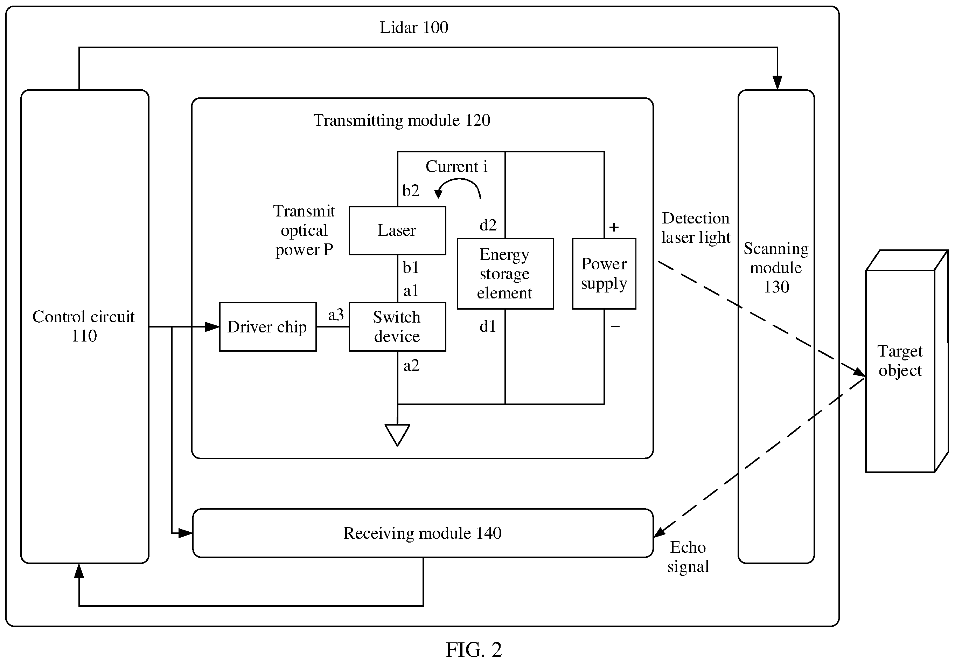

Further, FIG. 2 is a diagram of an internal architecture of the lidar according to an embodiment of this application. As shown in FIG. 2, the lidar 100 may include a control circuit 110, a transmitting module 120, a scanning module 130, and a receiving module 140. The transmitting module 120 and the receiving module 140 include optical elements such as one or more of a lens, a light filter, a polarizer, a reflector, a beam splitter, a prism, a window plate, and a scattering sheet. A quantity and types of optical elements specifically included are related to optical designs of the transmitting module 120 and the receiving module 140 in the lidar 100, and are not specifically limited in embodiments of this application. The transmitting module 120 may include at least one laser. The at least one laser may be connected in series or in parallel, and is configured to emit detection laser light under control of the control circuit 110. The scanning module 130 may include one or more of a multi-faceted rotating mirror, a swing mirror, a micro-electro-mechanical system (micro-electro-mechanical system, MEMS) scanning mirror, or a prism, and is configured to change, under control of the control circuit 110, a scanning angle of the detection laser light emitted by the transmitting module 120, so that the detection laser light can perform traversal scanning on a target object in an environment. In different types of lidars, implementations of the scanning module 130 are different, and there may alternatively be no scanning module in some types of lidars, for example, a phased array radar in the solid-state lidar. The detection laser light emitted by the transmitting module 120 is further reflected by the target object in the environment to generate an echo signal. The receiving module 140 may be configured to: under control of the control circuit 110, receive the echo signal corresponding to the detection laser light, convert the echo signal into an electrical signal, and send the electrical signal to the control circuit 110. The control circuit 110 determines a feature of the target object based on the electrical signal. It may be understood that the lidar 100 may alternatively include more or fewer components than those shown in FIG. 2. This is not specifically limited in embodiments of this application.

The control circuit 110 may include at least one integrated circuit chip. For example, the control circuit 110 may include at least one processor, and when the control circuit 110 includes a plurality of processors, types of the included processors may be the same or different. The processor is an element or a circuit having a processing capability, for example, including one or more of the following types: a general-purpose processor, a field programmable gate array (field programmable gate array, FPGA), an application-specific integrated circuit (application-specific integrated circuit, ASIC), a neural-network processing unit (neural-network processing unit, NPU), a graphics processing unit (graphics processing unit, GPU), an application processor (application processor, AP), a modem processor, an image signal processor (image signal processor, ISP), a video codec, a digital signal processor (digital signal processor, DSP), a baseband processor, a network processor (network processor, NP), a digital signal processing circuit (digital signal processor, DSP), a micro control unit (micro controller unit, MCU), a programmable controller (programmable logic device, PLD) or another programmable logic device, a discrete gate or a transistor logic device, a discrete hardware component, or another integrated chip. The general-purpose processor includes, for example, a central processing unit (central processing unit, CPU). In addition, all or some integrated circuit chips included in the control circuit 110 may be integrated together and presented in a form of a system on chip (system on chip, SoC).

In a possible implementation, still with reference to FIG. 2, the transmitting module 120 may include a driver chip, a switch device, the laser, an energy storage element, and a power supply. An input end of the driver chip is connected to the control circuit 110, and an output end of the driver chip is connected to a third end (a3) of the switch device. A first end (a1) of the switch device is connected to a first end (b1) of the laser. A second end (b2) of the laser is separately connected to a second end (d2) of the energy storage element and a positive electrode of the power supply. A second end (a2) of the switch device is separately connected to a first end (d1) of the energy storage element and a negative electrode of the power supply, and then is grounded (namely, a device marked with an inverted triangle "V" in FIG. 2, where grounding may mean that the component is connected to the ground through a conductor, or may mean that a grounding circuit is disposed and the component is connected to the grounding circuit, and this not specifically limited). The driver chip may be a chip that can drive the switch device to be turned on or turned off, and may be usually implemented by integrating a plurality of levels of drive devices into one electronic chip. The switch device may be any device that can implement turn-on and turn-off, for example, a field-effect transistor (field-effect transistor, FET). The FET may be an N-channel metal-oxide-semiconductor switch device (N-channel metal-oxide-semiconductor field-effect transistor, NMOSFET), or may be a P-channel metal-oxide-semiconductor switch device (P-channel metal-oxide-semiconductor field-effect transistor, PMOSFET). This is not specifically limited. The laser may be a single laser, or may be a laser chain formed by a plurality of lasers connected in series, or may be a laser ring formed by the plurality of lasers connected in parallel, or may be a laser array formed by the plurality of lasers connected in series and in parallel. A type of the laser may be an edge emitting laser (edge emitting laser, EEL), a surface emitting laser (surface emitting laser, SEL), or the like. The energy storage element may be an element that can store electric energy, for example, a capacitor (like a silicon capacitor) or an inductor.

In the foregoing implementation, in a process of controlling the transmitting module 120 to work, the control circuit 110 may send periodically repeated pulse control signals, for example, send, in an earlier time period of a periodicity, a first control signal used to turn off the switch device, and send, in a later time period of the periodicity, a second control signal used to turn on the switch device. In this way, in the earlier time period of the periodicity, the driver chip drives, based on the first control signal, the first end a1 and the second end a2 of the switch device to be disconnected. In this case, electric energy output by the power supply is provided to the energy storage element but is not provided to the laser. Therefore, the energy storage element can store the electric energy output by the power supply. Then, in the later time period of the periodicity, the driver chip drives, based on the second control signal, the first end a1 and the second end a2 of the switch device to be connected. In this case, the energy storage element that already stores the energy in the earlier time period starts to discharge, so that a transient current i is formed in a loop including the laser, the switch device, and the energy storage element. The transient current i drives the laser to emit the detection laser light. A larger value of the transient current i indicates a larger transmit optical power P of the laser. In this way, the laser in the transmitting module 120 also correspondingly periodically emits light under the periodically repeated pulse control signals of the control circuit 110.

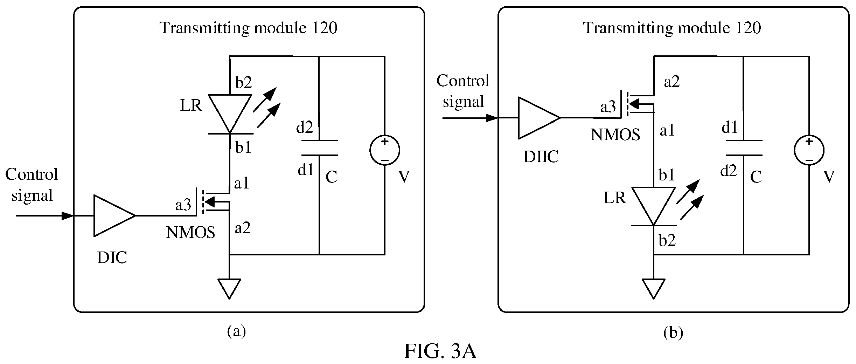

In this embodiment of this application, there are a plurality of possible connection manners for the components in the transmitting module 120. For example, it is assumed that the switch device is an NMOS transistor, the driver chip is a drive integrated circuit chip (driver integrated circuit chip, DIC), the laser is a single laser (laser, LR), and the energy storage element is a capacitor C. In this case, FIG. 3A is a diagram of an example of a component connection structure of the transmitting module according to an embodiment of this application.

In an example, as shown in (a) in FIG. 3A, the first end a1 of the switch device is a drain of the NMOS transistor, the second end a2 of the switch device is a source of the NMOS transistor, the third end a3 of the switch device is a gate of the NMOS transistor, the first end b1 of the laser is a cathode of the laser LR, and the second end b2 of the laser is an anode of the laser LR. A specific connection manner is as follows: An output end of the driver chip DIC is connected to the gate a3 of the NMOS transistor, the drain a1 of the NMOS transistor is connected to the cathode b1 of the laser LR, the anode b2 of the laser LR is separately connected to a second end d2 of the capacitor C and the positive electrode of the power supply, and the source a2 of the NMOS transistor is separately connected to a first end d1 of the capacitor C and the negative electrode of the power supply, and then grounded. According to the circuit connection structure, in the process of controlling the transmitting module 120 to work, the control circuit 110 may output a low-level first control signal to the driver chip DIC in an earlier time period of a periodicity, and output a high-level second control signal to the driver chip DIC in a later time period of the periodicity. In this way, in the earlier time period of the periodicity, the driver chip DIC drives, based on a low level, the source a2 and the drain a1 of the NMOSFET to be disconnected. In this case, the electric energy output by the power supply V cannot be provided to the laser LR, but can be provided to the capacitor C, to charge the capacitor C. In this case, because a link on which the laser LR is located is disconnected, the laser LR does not emit the detection laser light. Then, in the later time period of the periodicity, the driver chip DIC drives, based on a high level, the source a2 and the drain a1 of the NMOSFET to be connected. In this case, the link on which the laser LR is located is connected, and the capacitor C may discharge to the laser LR. Therefore, the laser LR may emit the detection laser light.

In another example, as shown in (b) in FIG. 3A, the first end a1 of the switch device is a source of the NMOS transistor, the second end a2 of the switch device is a drain of the NMOS transistor, the third end a3 of the switch device is a gate of the NMOS transistor, the first end b1 of the laser is an anode of the laser LR, and the second end b2 of the laser is a cathode of the laser LR. A specific connection manner is as follows: An output end of the driver chip DIC is connected to the gate a3 of the NMOS transistor, the source a1 of the NMOS transistor is connected to the cathode b1 of the laser LR, the anode b2 of the laser LR is separately connected to a second end d2 of the capacitor C and the negative electrode of the power supply, and then is grounded, and the drain a2 of the NMOS transistor is separately connected to a first end d1 of the capacitor C and the positive electrode of the power supply. A working process of the circuit connection structure shown in (b) in FIG. 3A is similar to the working process of the circuit connection structure shown in (a) in FIG. 3A. The reason is as follows: The capacitor C is actually formed by two conductors that are insulated from each other and approach each other. In the circuit connection structure shown in (a) in FIG. 3A, when the capacitor C is charged in the earlier time period, a conductor forming the second end d2 of the capacitor C is positively charged and a conductor forming the first end d1 of the capacitor C is negatively charged. Therefore, during discharge in the later time period, electric energy output by the conductor forming the second end d2 of the capacitor C flows back to the conductor forming the first end d1 of the capacitor C after sequentially flowing through the anode b2 of the laser LR, the cathode b1 of the laser LR, the drain a1 of the NMOS transistor, and the source a2 of the NMOS transistor, and drives the laser LR to emit light. Similarly, in the circuit connection structure shown in (b) in FIG. 3A, when the capacitor C is charged in the earlier time period, a conductor forming the first end d1 of the capacitor C is positively charged and a conductor forming the second end d2 of the capacitor C is negatively charged. Therefore, during discharge in the later time period, electric energy output by the conductor forming the first end d1 of the capacitor C flows back to the conductor forming the second end d2 of the capacitor C after sequentially flowing through the drain a2 of the NMOS transistor, the source a1 of the NMOS transistor, the anode b1 of the laser LR, and the cathode b2 of the laser LR, and drives the laser LR to emit light.

The foregoing content is merely examples for describing two possible component connection manners of the transmitting module 120. During actual operation, some variations may be made to the connection manners shown above, and fall within the protection scope of embodiments of this application provided that a transmit function of the transmitting module 120 is not affected. This is not specifically limited in embodiments of this application.

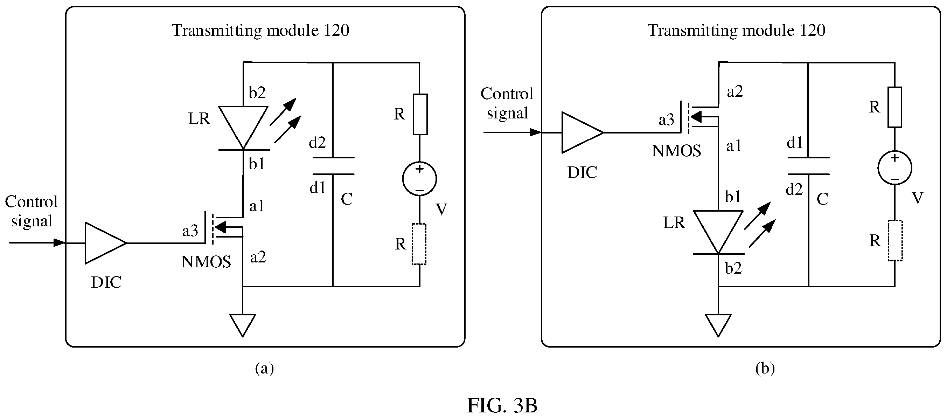

In addition, some variations may be made to the components included in the transmitting module 120. For example, a part of the components in the transmitting module 120 are modified to other components that can implement same functions. For example, the NMOS transistor is replaced with a diode or a PMOS transistor. When the NMOS transistor is replaced with the PMOS transistor, the PMOS transistor is turned on at the low level and turned off at the high level. Therefore, if the control circuit still sends the low-level first control signal in an earlier time period of a periodicity, and sends the high-level second control signal in a later time period of the periodicity, the laser sends the detection laser light in the earlier time period of the periodicity, and does not emit the detection laser light in the later time period of the periodicity. For another example, some components may be added to or deleted from the transmitting module 120. In a possible example, as shown in (a) in FIG. 3B or (b) in FIG. 3B, the transmitting module 120 may further include a resistance element R. The resistance element R is connected in series to the power supply V. For example, in an example, as shown in (a) in FIG. 3B, a first end of the resistance element R is connected to the positive electrode of the power supply V, and a second end of the resistance element R is connected to the anode b2 of the laser LR and the second end d2 of the capacitor C; or the first end of the resistance element R is connected to the negative electrode of the power supply V, and the second end of the resistance element R is connected to the source a2 of the NMOS transistor and the first end d1 of the capacitor C and then grounded. Alternatively, in another example, as shown in (b) in FIG. 3B, a first end of the resistance element R is connected to the positive electrode of the power supply V, and a second end of the resistance element R is connected to the drain a2 of the NMOS transistor and the first end d1 of the capacitor C; or the first end of the resistance element R is connected to the negative electrode of the power supply V, and the second end of the resistance element R is connected to the cathode b2 of the laser LR and the second end d2 of the capacitor C and then grounded. For a working process of the circuit connection structure, refer to that of the circuit connection structure shown in (a) in FIG. 3A or (b) in FIG. 3A. A difference lies in that, in an earlier time period of a periodicity, one part of the electric energy output by the power supply V is consumed by the resistance element R, and the other part of the electric energy is provided to the capacitor C. In other words, after charging is completed, electric energy stored by the capacitor C is less than that in the structure shown in (a) in FIG. 3A or (b) in FIG. 3A. In a later time period of the periodicity, the capacitor C, the resistor R, and the laser LR form a loop. Therefore, a current on the loop is less than that on a loop formed by only the capacitor C and the laser LR shown in (a) in FIG. 3A or (b) in FIG. 3A, and intensity of detection laser light emitted by the laser LR is weaker than that in the structure shown in (a) in FIG. 3A or (b) in FIG. 3A. In addition, if the intensity of the detection laser light needs to be flexibly adjusted, the resistance element R may be further set to have a variable resistance. When detection laser light with weaker intensity needs to be emitted, a resistance value of the variable resistance is set to a larger value. When detection laser light with stronger intensity needs to be emitted, the resistance value of the variable resistor is set to a smaller value.

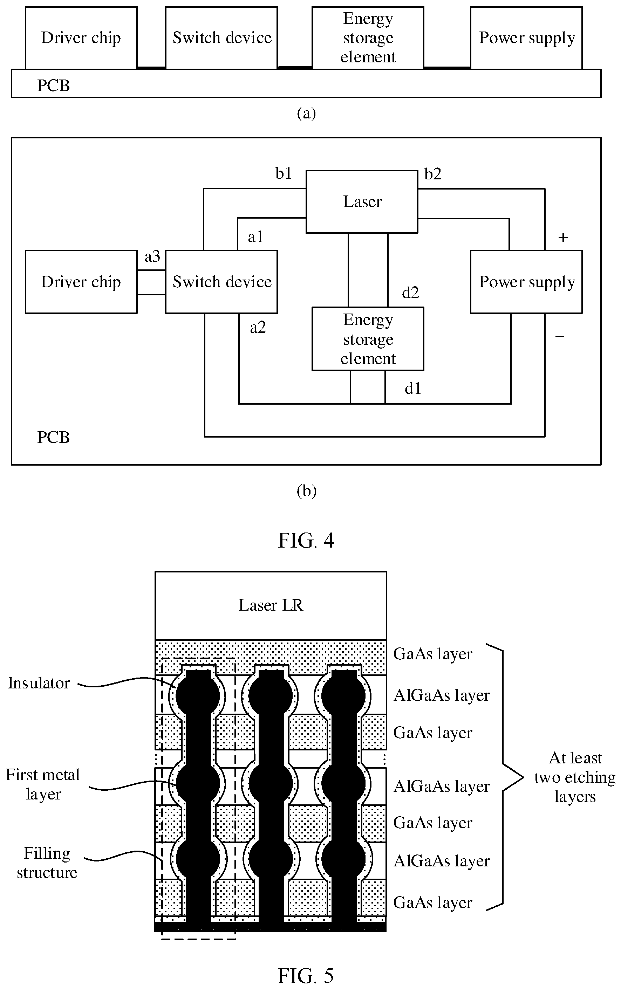

Further, with reference to FIG. 2, FIG. 4 is a diagram of a layout manner of the components in the transmitting module, where (a) in FIG. 4 is a main view of the layout manner of the components in the transmitting module, and (b) in FIG. 4 is a top view of the layout manner of the components in the transmitting module. As shown in (a) in FIG. 4 and (b) in FIG. 4, in the layout manner, a PCB board is disposed, the driver chip, the switch device, the laser, the energy storage element, and the power supply in the transmitting module 120 are all separately packaged into packages, and then are laid out on the PCB board in a planar manner, and the packages are connected to each other through a trace on the PCB. In a partial circuit structure, parasitics (for example, parasitic resistance and parasitic inductance) are introduced in the circuit structure due to a quantity of packages and a trace that are included in the circuit structure, and the introduced parasitics are connected in series to a link on which the laser is located. It is assumed that the parasitic resistance is R, the parasitic inductance is L, an output power of the power supply is Pₒᵤₜ, and a photoelectric conversion efficiency is η. It can be learned from the working principle of the transmitting module described above that the transient current i is formed when the energy storage element discharges after the switch device is turned on. As the parasitic inductance L and the parasitic resistance R that are connected in series to the link on which the laser is located decrease, the transient current i correspondingly increases, so that a transmit optical power P of the laser also increases, that is, the transmit optical power P of the laser is approximately proportional to the transient current i, and the transient current i is approximately proportional to 1/LR. Therefore, the transmit optical power P of the laser may be understood as being approximately proportional to 1/LR. In this way, under the same output power Pₒᵤₜ of the power supply, the photoelectric conversion efficiency η may be defined as a ratio of the transmit optical power P of the laser to the output power Pₒᵤₜ of the power supply, that is, η=P/Pₒᵤₜ. Because P is approximately proportional to 1/LR, the photoelectric conversion efficiency η may be approximately proportional to 1/LR. In conclusion, reducing the parasitic inductance L and the parasitic resistance R can improve the photoelectric conversion efficiency η in the transmitting module.

However, a larger quantity of packages and a longer trace that are included in the circuit structure indicate larger parameter values of parasitic inductance and parasitic resistance that are introduced in the circuit structure. In the foregoing layout manner, separately packaging each component causes a large quantity of packages in the transmitting module, and a plane layout of the packages causes a winding trace on the PCB board. Great parasitic inductance and parasitic resistance are introduced in the transmitting module due to both the large quantity of packages and the winding trace. As a result, a transmit optical power of the detection laser light emitted by the laser is reduced. It can be learned that the foregoing layout manner reduces efficiency of converting the electric energy into optical energy by the transmitting module, and is not conducive to improving the photoelectric conversion efficiency of the transmitting module.

In view of this, embodiments of this application provide an integrated apparatus, to reduce parasitics introduced in a structure of the integrated apparatus, so as to improve effective energy conversion efficiency of the integrated apparatus. For example, when the integrated apparatus integrates a laser and a capacitor that are in a transmitting module, parasitics introduced in the transmitting module are reduced, to improve photoelectric conversion efficiency of the transmitting module.

The following describes, by using specific embodiments, a specific implementation of the integrated apparatus provided in embodiments of this application.

FIG. 5 is a diagram of a structure of an integrated apparatus according to an embodiment of this application. The integrated apparatus includes: a substrate, having at least two etching layers that are alternately stacked; and a laser LR, located on the substrate. At least one filling structure is disposed on a side that is of the substrate and that is away from the laser LR. The filling structure includes an insulator and a first metal layer. A height of the filling structure is less than a thickness of the substrate.

The at least two etching layers may include two or more etching layers. The etching layer may be a dielectric layer in which a through hole or a groove can be formed through etching or photoetching. The at least one filling structure may include one or more filling structures. The filling structure may be embedded into the side that is of the substrate and that is away from the laser LR, and a height of a part that is of the filling structure and that is embedded into the substrate is less than the thickness of the substrate, that is, the filling structure does not penetrate the substrate.

In addition, the laser LR may be a laser diode. Optionally, the laser LR may be a laser that can emit laser light of different wavelengths. For example, the wavelength may be 905 nanometers (nm). In an example, the laser LR includes an anode and a cathode, and the anode is embedded into the substrate and does not penetrate the substrate.

In addition, the insulator may be located between the substrate and the first metal layer, and is attached to the first metal layer. In this case, the substrate and the filling structure may form a capacitor C. In other words, the laser LR and the capacitor C may share the same sub strate, and are respectively disposed on two opposite sides of the substrate. Optionally, the substrate may be a wafer.

Optionally, the filling structure has different radial widths in the at least two etching layers. In this way, when the substrate and the filling structure form the capacitor C, the capacitor C can have a large specific surface area. The specific surface area may be a total surface area of a substance per unit mass.

In the integrated apparatus provided in this embodiment of this application, the laser LR and the capacitor C are disposed on the same substrate, to reduce a distance between the laser LR and the capacitor C in a three-dimensional layout manner, and implement an interconnection between the laser LD and the capacitor C. Therefore, no extra interconnection trace needs to be disposed between the laser LD and the capacitor. This greatly reduces parasitics (for example, parasitic inductance and parasitic resistance) introduced in the structure of the integrated apparatus, thereby improving effective energy conversion efficiency of the integrated apparatus. The substrate has the at least two etching layers that are alternately stacked, so that the at least one filling structure disposed in the substrate can have different radial widths in different etching layers. This increases the specific surface area of the capacitor C, thereby facilitating heat dissipation and reducing a heat loss.

Optionally, the at least two etching layers have different etching selective materials. In a possible example, the at least two etching layers have two etching selective materials, and may specifically include an aluminum gallium arsenide AlGaAs layer and a gallium arsenide GaAs layer. In other words, the substrate includes the AlGaAs layer and the GaAs layer that are alternately stacked. During actual application, the materials of the at least two etching layers in this application may alternatively be other materials. In this embodiment of this application, only an example in which the materials include AlGaAs and GaAs is used for description, and constitutes no limitation on embodiments of this application.

When the two etching layers include the AlGaAs layer and the GaAs layer, a lattice constant of AlGaAs is different from a lattice constant of the GaAs layer, and the lattice constant of the AlGaAs is less than the lattice constant of the GaAs layer. Therefore, the AlGaAs layer and the GaAs layer undergo compression strain in an x direction and a y direction (namely, two directions parallel to the etching layer and perpendicular to each other), and undergo tensile strain in a z direction (namely, a direction perpendicular to the etching layer). In this way, electrons in the AlGaAs layer and the GaAs layer have large mobility, and a corresponding resistivity is low. This greatly reduces the parasitic resistance of the integrated apparatus, and improves performance of the integrated apparatus. In addition, because conductivity of the AlGaAs is good, resistance of the AlGaAs layer can be further reduced by using the AlGaAs layer, to further improve performance of the integrated apparatus.

Optionally, when the at least two etching layers include the AlGaAs layer and the GaAs layer, the GaAs layer may be an etching layer closest to the laser in the at least two etching layers. In addition, a thickness of the AlGaAs layer may be the same as or different from a thickness of the GaAs layer. In an example, as shown in FIG. 5, the thickness of the AlGaAs layer is the same as the thickness of the GaAs layer.

In the foregoing embodiment, an etching resistance of the AlGaAs layer may be greater than an etching resistance of the GaAs layer. Correspondingly, a radial width of the filling structure in the AlGaAs layer may be greater than a radial width of the filling structure in the GaAs layer. In this way, the filling structure has different radial widths in the AlGaAs layer and the GaAs layer that are alternately stacked.

In a possible embodiment, a part that is of the filling structure and that is located in the AlGaAs layer is distributed in a straight line, and a part that is of the filling structure and that is located in the GaAs layer is distributed in an arc line. The part that is of the filling structure and that is located in the AlGaAs layer is distributed in the straight line, and the part that is of the filling structure and that is located in the GaAs layer is distributed in the arc line, so that the filling structure can have a large surface area. This increases the specific surface area of the capacitor C, thereby facilitating heat dissipation and reducing a heat loss.

Optionally, the at least one filling structure includes the plurality of filling structures. In a possible embodiment, distances between any two adjacent filling structures in the plurality of filling structures may be the same or different. In FIG. 5, an example in which the distances between the any two adjacent filling structures are the same is used for description.

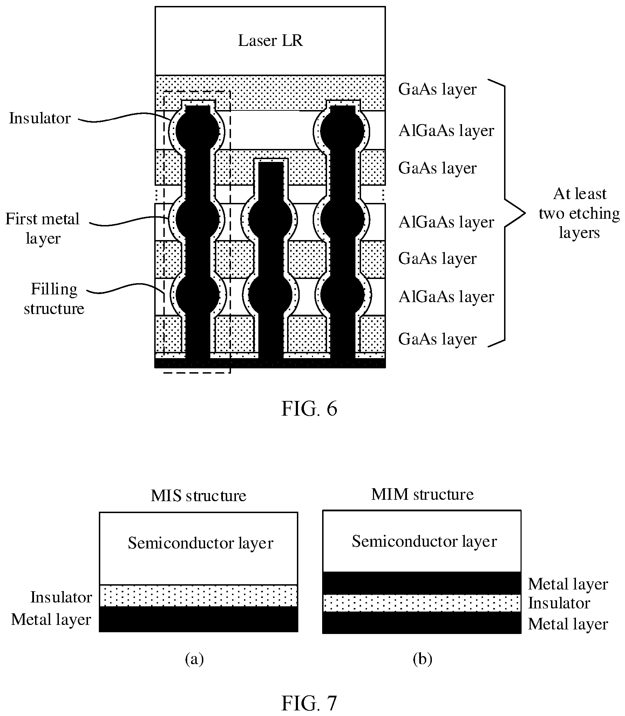

Further, the plurality of filling structures may be in a comb shape. Heights of at least two comb teeth in the plurality of filling structures may be the same or different. A height of each comb tooth herein may be a height at which the comb tooth extends into the substrate. In an example, as shown in FIG. 5, heights of the plurality of filling structures are the same. Alternatively, in another example, as shown in FIG. 6, in the plurality of filling structures, heights of partial comb teeth are different from a height of another comb tooth. When a comb tooth with a different height exists in the plurality of filling structures, comb teeth with different heights may be randomly arranged, or may be arranged in a specific order (for example, in ascending order, in descending order, or in an order in which a high comb tooth is followed by a low comb tooth, the low comb tooth is followed by another high comb tooth, the another high comb tooth is followed by another low comb tooth, and the like). This is not specifically limited in embodiments of this application.

Optionally, when the plurality of filling structures are in the comb shape, insulators in the plurality of filling structures may be connected together and are in a "bow" shape. First metal layers in the plurality of filling structures may also be connected together and are in a comb shape.

In this embodiment of this application, as shown in (a) and (b) in FIG. 7, the capacitor C may be a capacitor with a metal layer-insulator-semiconductor layer (metal-insulator-semiconductor, MIS) structure, or may be a capacitor with a metal layer-insulator-metal layer (metal-insulator-metal, MIM) structure. When being the MIS structure, the capacitor C may include the substrate, the insulator, and the first metal layer. In this case, the substrate may be a heavily doped substrate. For example, the substrate includes heavily doped AlGaAs and heavily doped gallium arsenide GaAs that are alternately stacked. The heavily doped substrate may also be referred to as a low-resistivity substrate. When being the MIM structure, in addition to the substrate, the insulator, and the first metal layer, the capacitor C may further include another metal layer. In this case, the substrate may be a lightly doped or non-doped substrate. The lightly doped or non-doped substrate may also be referred to as a high-resistivity substrate.

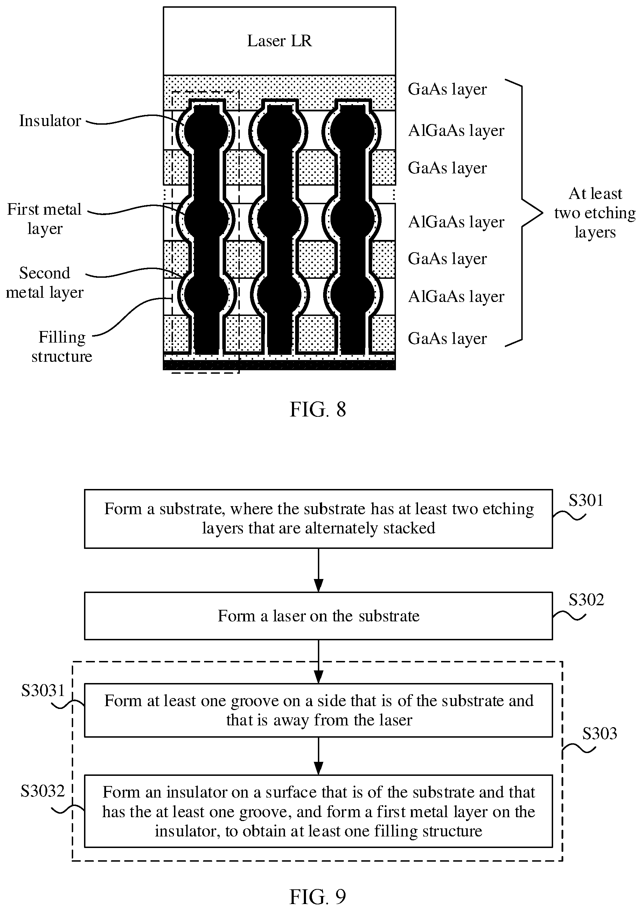

When the substrate is a high-resistivity substrate, in a possible embodiment, as shown in FIG. 8, the filling structure further includes a second metal layer. The second metal layer is located between the substrate and the insulator. A shape of the second metal layer may also be a "bow" shape. Optionally, the second metal layer may be formed before the insulator. For example, after a groove is etched on the side that is of the substrate and that is away from the laser LR, the second metal layer may be formed by depositing a metal material on a side surface that is of the substrate and that has the groove, and then the insulator is formed by depositing an insulation material on the second metal layer.

In the integrated apparatus provided in this embodiment of this application, the capacitor C with the MIS structure can be implemented by using the high-resistivity substrate, the insulator, and the first metal layer, or the capacitor C with the MIM structure can be implemented by using the low-resistivity substrate, the second metal layer, the insulator, and the first metal layer. Therefore, during specific implementation, flexibility and diversity of the capacitor C in the integrated apparatus can be improved.

In view of this, an embodiment of this application further provides an integrated circuit. The integrated circuit includes the integrated apparatus provided above and a switch device. The switch device is coupled to the integrated apparatus.

An embodiment of this application further provides a transmitting module. The transmitting module may include a power supply, a driver chip, and the integrated apparatus provided above. The power supply is configured to supply power to the integrated apparatus. The driver chip is configured to send a drive signal to the integrated apparatus. The integrated apparatus is configured to send detection laser light based on the drive signal.

An embodiment of this application further provides a detection apparatus. The detection apparatus may include a control circuit and the transmitting module provided above. The control circuit is configured to send a control signal to the transmitting module. The transmitting module is configured to send detection laser light based on the control signal.

In a possible embodiment, the detection apparatus may further include a receiving module. The receiving module is configured to: receive an echo signal returned after the detection laser light scans a target object, and convert the echo signal into an electrical signal. The control circuit is further configured to process the electrical signal to obtain point cloud data.

In another possible embodiment, the detection apparatus may further include a scanning module. The scanning module is configured to traverse and scan for a target object by using the detection laser light.

Optionally, the detection apparatus may be a lidar, or another apparatus that can emit the detection laser light. For example, some examples of the detection apparatus include but are not limited to a vehicle-mounted lidar, a laser sensor of a robotic vacuum cleaner, a laser detection module at a dock, a laser printer, and the like.

An embodiment of this application further provides a terminal, including the detection apparatus described in the foregoing content. Optionally, the terminal includes but is not limited to: a smart home device (for example, a television, a robotic vacuum cleaner, a smart desk lamp, an acoustic system, an intelligent lighting system, an electrical control system, home background music, a home theater system, an intercom system, and a video surveillance), an intelligent transportation device (for example, a vehicle like a car, a ship, an uncrewed aerial vehicle, a train, a lorry, or a truck), an intelligent manufacturing device (for example, a robot, an industrial device, intelligent logistics, or a smart factory), or an intelligent terminal (a mobile phone, a computer, a tablet computer, a tablet computer, a desktop computer, a headset, a speaker, a wearable device, a vehicle-mounted device, a virtual reality device, an augmented reality device, and the like).

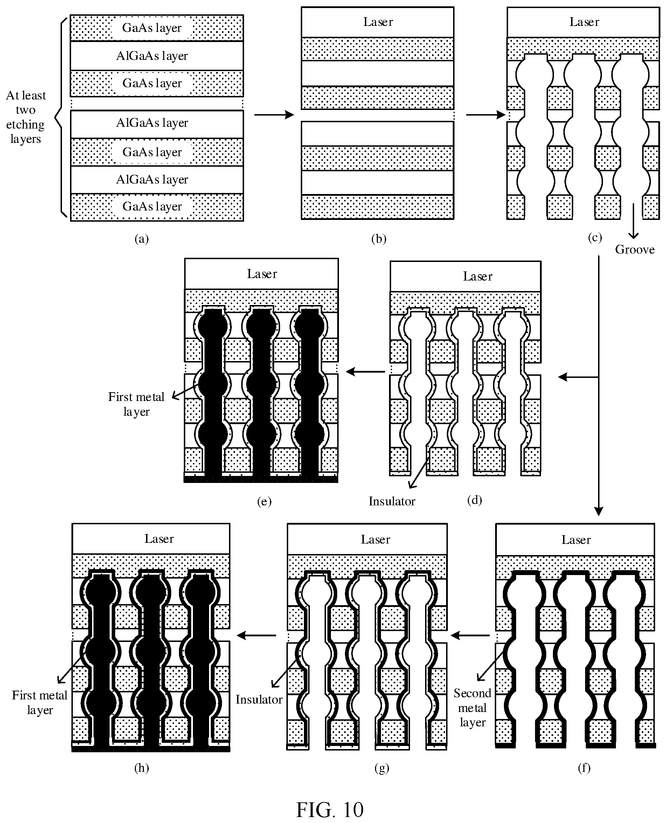

FIG. 9 is a schematic flowchart of a manufacturing method for an integrated apparatus according to an embodiment of this application. The integrated apparatus may be the integrated apparatus provided above. The method includes the following several steps. FIG. 10 is a cross-sectional view of the integrated apparatus in a manufacturing process.

S301: Form a substrate, where the substrate has at least two etching layers that are alternately stacked, as shown in (a) in FIG. 10.

The at least two etching layers may include two or more etching layers. The etching layer may be a dielectric layer in which a through hole or a groove can be formed through etching or photoetching. At least one filling structure may include one or more filling structures. The filling structure may be embedded into a side that is of the substrate and that is away from a laser LR, and a height of a part that is of the filling structure and that is embedded into the substrate is less than a thickness of the substrate, that is, the filling structure does not penetrate the substrate.

In addition, the laser LR may be a laser diode. Optionally, the laser LR may be a laser that can emit laser light of different wavelengths. For example, the wavelength may be 905 nanometers (nm).

In addition, an insulator may be located between the substrate and a first metal layer, and is attached to the first metal layer. In this case, the substrate and the filling structure may form a capacitor C. In other words, the laser LR and the capacitor C may share the same substrate, and are respectively disposed on two opposite sides of the substrate. Optionally, the substrate may be a wafer.

Optionally, the at least two etching layers have different etching selective materials. In a possible example, the at least two etching layers have two etching selective materials, and may specifically include an aluminum gallium arsenide AlGaAs layer and a gallium arsenide GaAs layer. In other words, the substrate includes the AlGaAs layer and the GaAs layer that are alternately stacked. During actual application, the materials of the at least two etching layers in this application may alternatively be other materials. In this embodiment of this application, only an example in which the materials include AlGaAs and GaAs is used for description, and constitutes no limitation on embodiments of this application.

In a possible embodiment, the at least two etching layers include the AlGaAs layer and the GaAs layer. Correspondingly, the forming a substrate may specifically include: alternately forming the AlGaAs layer and the GaAs layer, to form the substrate having the AlGaAs layer and the GaAs layer that are alternately stacked.

S302: Form a laser on the substrate, as shown in (b) in FIG. 10.

Optionally, when the at least two etching layers include the AlGaAs layer and the GaAs layer, the GaAs layer may be an etching layer closest to the laser in the at least two etching layers. In addition, a thickness of the AlGaAs layer may be the same as or different from a thickness of the GaAs layer.

In a possible embodiment, a last layer in the AlGaAs layer and the GaAs layer that are alternately stacked is the GaAs layer. The forming a laser on the substrate may specifically include: forming the laser on the GaAs layer of the substrate. For example, the laser LR includes an anode and a cathode. The cathode is formed on the GaAs layer of the substrate, and the anode is embedded into the substrate for formation, where the anode does not penetrate the substrate.

S303: Form the at least one filling structure on the side that is of the substrate and that is away from the laser, where the filling structure includes an insulator and a first metal layer, and a height of the filling structure is less than a thickness of the substrate.

In the foregoing embodiment, an etching resistance of the AlGaAs layer may be greater than an etching resistance of the GaAs layer. Correspondingly, a radial width of the filling structure in the AlGaAs layer may be greater than a radial width of the filling structure in the GaAs layer. In this way, the filling structure has different radial widths in the AlGaAs layer and the GaAs layer that are alternately stacked.

In a possible embodiment, a part that is of the filling structure and that is located in the AlGaAs layer is distributed in a straight line, and a part that is of the filling structure and that is located in the GaAs layer is distributed in an arc line.

Optionally, the at least one filling structure includes the plurality of filling structures. In a possible embodiment, distances between any two adjacent filling structures in the plurality of filling structures may be the same or different.

Further, the plurality of filling structures may be in a comb shape. Heights of at least two comb teeth in the plurality of filling structures may be the same or different. A height of each comb tooth herein may be a height at which the comb tooth extends into the substrate. In an example, heights of the plurality of filling structures are the same. Alternatively, in another example, in the plurality of filling structures, heights of partial comb teeth are different from a height of another comb tooth. When a comb tooth with a different height exists in the plurality of filling structures, comb teeth with different heights may be randomly arranged, or may be arranged in a specific order (for example, in ascending order, in descending order, or in an order in which a high comb tooth is followed by a low comb tooth, the low comb tooth is followed by another high comb tooth, the another high comb tooth is followed by another low comb tooth, and the like). This is not specifically limited in embodiments of this application.

Optionally, when the plurality of filling structures are in the comb shape, insulators in the plurality of filling structures may be connected together and are in a "bow" shape. First metal layers in the plurality of filling structures may also be connected together and are in a comb shape.

In a possible embodiment, the insulator is located between the substrate and the first metal layer. As shown in FIG. 9, S303 may specifically include S3031 and S3032.

S3031: Form at least one groove on the side that is of the substrate and that is away from the laser, where a height of the groove is less than the thickness of the substrate, as shown in (c) in FIG. 10.

The at least one groove may include a plurality of grooves, and distances between any two adjacent grooves in the plurality of grooves may be the same or different. In addition, heights of at least two grooves in the plurality of grooves may be the same or different. For example, heights of the plurality of grooves are the same, or heights of partial grooves in the plurality of grooves are different from a height of another groove. In FIG. 10, an example in which the distances between the any two adjacent grooves are the same and the heights of the plurality of grooves are the same is used for description.

In a possible embodiment, in this application, the at least one groove may be formed on the side that is of the substrate and that is away from the laser by using a process like photoetching or etching.

S3032: Form the insulator on a surface that is of the substrate and that has the at least one groove, and form the first metal layer on the insulator, to obtain the at least one filling structure, as shown in (d) and (e) in FIG. 10.

In a possible embodiment, the insulator is formed on a surface that is of the substrate and that has the at least one groove by using a process like sedimentation or deposition of an insulation material. A thickness of the insulator is less than one half of a radial width of the groove. Then, the first metal layer may be formed on the insulator by using a process like sedimentation or deposition of a metal material. A sum of the thickness of the insulator and a thickness of the first metal layer may be equal to the half of the radial width of the groove.

The capacitor C may be a capacitor with a MIS structure, or may be a capacitor with a MIM structure. When being the MIS structure, the capacitor C may include the substrate, the insulator, and the first metal layer. In this case, the substrate may be a heavily doped substrate. The heavily doped substrate may also be referred to as a low-resistivity substrate. When being the MIM structure, in addition to the substrate, the insulator, and the first metal layer, the capacitor C may further include another metal layer. In this case, the substrate may be a lightly doped or non-doped substrate. The lightly doped or non-doped substrate may also be referred to as a high-resistivity substrate.

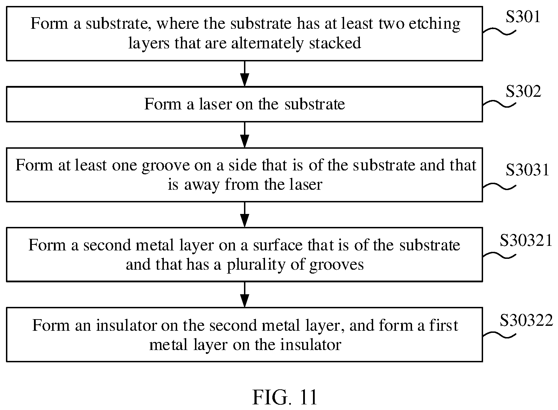

Further, the substrate is a high-resistivity substrate, and the capacitor further includes a second metal layer. The second metal layer is located between the substrate and the insulator. In this case, as shown in FIG. 11, S3032 may specifically include S30321 and S30322.

S30321: Form the second metal layer on the surface that is of the substrate and that has the plurality of grooves, as shown in (f) in FIG. 10.

In a possible embodiment, the second metal layer is formed, by using a process like sedimentation or deposition of a metal material, on the surface that is of the substrate and that has the at least one groove. A thickness of the second metal layer is less than the half of the radial width of the groove.

S30322: Form the insulator on the second metal layer, and form the first metal layer on the insulator, as shown in (g) and (h) in FIG. 10.

In a possible embodiment, the insulator is formed on the second metal layer by using the process like sedimentation or deposition of the insulation material. A sum of the thickness of the insulator and a thickness of the second metal layer is less than the half of the radial width of the groove. Then, the first metal layer may be formed on the insulator by using the process like sedimentation or deposition of the metal material. A sum of the thickness of the second metal layer, the thickness of the insulator, and the thickness of the first metal layer is equal to the half of the radial width of the groove.

In the manufacturing method for an integrated apparatus provided in this embodiment of this application, the laser LR and the capacitor C are disposed on the same substrate, to reduce a distance between the laser LR and the capacitor C in a three-dimensional layout manner, and implement an interconnection between the laser LD and the capacitor C. Therefore, no extra interconnection trace needs to be disposed between the laser LD and the capacitor. This greatly reduces parasitics (for example, parasitic inductance and parasitic resistance) introduced in a structure of the integrated apparatus, thereby improving effective energy conversion efficiency of the integrated apparatus. The substrate has the at least two etching layers that are alternately stacked, so that the at least one filling structure disposed in the substrate can have different radial widths in different etching layers. This increases a specific surface area of the capacitor C, thereby facilitating heat dissipation and reducing a heat loss.

Based on the manufacturing method provided in embodiments of this application, an embodiment of this application further provides a computer-readable storage medium. The computer-readable storage medium stores a computer program. When the computer program is run, the manufacturing method described in the foregoing content is performed.

Based on the manufacturing method provided in embodiments of this application, an embodiment of this application further provides a computer program product. When the computer program product runs on a processor, the manufacturing method described in the foregoing content is implemented.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An integrated apparatus, wherein the integrated apparatus comprises:
a substrate, having at least two etching layers that are alternately stacked; and
a laser, located on the substrate, wherein
at least one filling structure is disposed on a side that is of the substrate and that is away from the laser, the filling structure comprises an insulator and a first metal layer, and a height of the filling structure is less than a thickness of the substrate.

2. The integrated apparatus according to claim 1, wherein the filling structure has different radial widths in the at least two etching layers.

3. The integrated apparatus according to claim 1 or 2, wherein the at least two etching layers have different etching selective materials.

4. The integrated apparatus according to claim 3, wherein the at least two etching layers comprise an aluminum gallium arsenide AlGaAs layer and a gallium arsenide GaAs layer.

5. The integrated apparatus according to claim 4, wherein the GaAs layer is an etching layer closest to the laser in the at least two etching layers.

6. The integrated apparatus according to claim 4 or 5, wherein a thickness of the AlGaAs layer is the same as a thickness of the GaAs layer.

7. The integrated apparatus according to any one of claims 4 to 6, wherein an etching resistance of the AlGaAs layer is greater than an etching resistance of the GaAs layer.

8. The integrated apparatus according to any one of claims 4 to 7, wherein a radial width of the filling structure in the AlGaAs layer is greater than a radial width of the filling structure in the GaAs layer.

9. The integrated apparatus according to any one of claims 4 to 8, wherein a part that is of the filling structure and that is located in the AlGaAs layer is distributed in a straight line, and a part that is of the filling structure and that is located in the GaAs layer is distributed in an arc line.

10. The integrated apparatus according to any one of claims 1 to 9, wherein the insulator is located between the substrate and the first metal layer, and is attached to the first metal layer.

11. The integrated apparatus according to any one of claims 1 to 10, wherein the filling structure further comprises a second metal layer, and the second metal layer is located between the substrate and the insulator.

12. The integrated apparatus according to any one of claims 1 to 11, wherein the at least one filling structure comprises a plurality of filling structures.

13. The integrated apparatus according to claim 12, wherein the plurality of filling structures are in a comb shape.

14. A manufacturing method for an integrated apparatus, wherein the method comprises:
forming a substrate, wherein the substrate has at least two etching layers that are alternately stacked;
forming a laser on the substrate; and
forming at least one filling structure on a side that is of the substrate and that is away from the laser, wherein the filling structure comprises an insulator and a first metal layer, and a height of the filling structure is less than a thickness of the substrate.

15. The manufacturing method according to claim 14, wherein the filling structure has different radial widths in the at least two etching layers.

16. The manufacturing method according to claim 14 or 15, wherein the at least two etching layers have different etching selective materials.

17. The manufacturing method according to claim 16, wherein the at least two etching layers comprise an aluminum gallium arsenide AlGaAs layer and a gallium arsenide GaAs layer; and
the forming a substrate comprises: alternately forming the AlGaAs layer and the GaAs layer, to form the substrate having the AlGaAs layer and the GaAs layer that are alternately stacked.

18. The manufacturing method according to claim 17, wherein a last layer in the AlGaAs layer and the GaAs layer that are alternately stacked is the GaAs layer, and the forming a laser on the substrate comprises:
forming the laser on the GaAs layer of the substrate.

19. The manufacturing method according to claim 17 or 18, wherein a thickness of the AlGaAs layer is the same as a thickness of the GaAs layer.

20. The manufacturing method according to any one of claims 17 to 19, wherein a radial width of the filling structure in the AlGaAs layer is greater than a radial width of the filling structure in the GaAs layer.

21. The manufacturing method according to any one of claims 17 to 20, wherein a part that is of the filling structure and that is located in the AlGaAs layer is distributed in a straight line, and a part that is of the filling structure and that is located in the GaAs layer is distributed in an arc line.

22. The manufacturing method according to any one of claims 14 to 21, wherein the insulator is located between the substrate and the first metal layer, and the forming at least one filling structure on a side that is of the substrate and that is away from the laser comprises:
etching the side that is of the substrate and that is away from the laser, to form at least one groove, wherein a height of the groove is less than the thickness of the substrate;
forming the insulator on a surface that is of the substrate and that has the at least one groove, wherein a thickness of the insulator is less than one half of a radial width of the groove; and
forming the first metal layer on the insulator, to obtain the at least one filling structure.

23. The manufacturing method according to claim 22, wherein the filling structure further comprises a second metal layer, the second metal layer is located between the substrate and the insulator, and the forming the insulator on a surface that is of the substrate and that has the at least one groove comprises:
forming the second metal layer on the surface that is of the substrate and that has the at least one groove; and
forming the insulator on the second metal layer, wherein a sum of a thickness of the second metal layer and the thickness of the insulator is less than the half of the radial width of the groove.

24. The manufacturing method according to any one of claims 14 to 23, wherein the at least one filling structure comprises a plurality of filling structures.

25. The manufacturing method according to claim 24, wherein the plurality of filling structures are in a comb shape.

26. A detection apparatus, wherein the detection apparatus comprises the integrated apparatus according to any one of claims 1 to 13.

27. A terminal, wherein the terminal comprises the integrated apparatus according to any one of claims 1 to 13.

28. The terminal according to claim 27, wherein the terminal is a vehicle.
